# EUROPEAN PATENT SPECIFICATION

(11) **EP 4 589 664 B1**
(45) Date of publication and mention of the grant of the patent: **27.05.2026**
(21) Application number: 24153144.1
(22) Date of filing: 22.01.2024
(51) Int. Cl.: H10F 10/166, H10F 77/20

(54) **PHOTOVOLTAIC DEVICE AND ITS METHOD OF MANUFACTURE**
FOTOVOLTAISCHE VORRICHTUNG UND VERFAHREN ZU IHRER HERSTELLUNG
DISPOSITIF PHOTOVOLTAÏQUE ET SON PROCÉDÉ DE FABRICATION

(43) Date of publication of application: 23.07.2025
(73) Proprietor: CSEM Centre Suisse d'Electronique et de Microtechnique SA - Recherche et Développement, 2002 Neuchâtel (CH)
(72) Inventor: BALLIF, Christophe, 2000 Neuchâtel (CH); LACHOWICZ, Agata, 8032 Zürich (CH); PAVIET-SALOMON, Bertrand, 2074 Marin (CH)
(74) Representative: Patentsmith SA

(56) References cited:
- EP-B1- 2 489 076
- WO-A1-2023/213024
- CN-A- 113 611 774
- US-B2- 8 236 604
- US-B2- 9 246 026
- GRUBEL BENJAMIN ET AL: "Direct Contact Electroplating Sequence Without Initial Seed Layer for Bifacial TOPCon Solar Cell Metallization", IEEE JOURNAL OF PHOTOVOLTAICS, IEEE, vol. 11, no. 3, 11 February 2021 (2021-02-11), pages 584 - 590, XP011850549, ISSN: 2156-3381, [retrieved on 20210420], DOI: 10.1109/JPHOTOV.2021.3051636

## Description

### Technical Field

The present invention relates to the field of photovoltaics. More particularly, it relates to a photovoltaic device comprising a non-fired-through electrical contact structure, as well as to its method of manufacture.

### State of the Art

Conventional solar cells like PERC (Passivated Emitter and Rear Cell) feature a metallization grid with direct contact of the metal to the silicon substrate. This direct contact leads to recombination of photogenerated charge carriers underneath the metal grid and limits the photoconversion efficiency. By implementation of layers providing simultaneously selective conduction of charge carriers and effective passivation of the silicon surface, these recombination losses are reduced and higher efficiency can be achieved.

There are two main types of cells with passivating contacts. The first type of cells are heterojunction solar cells having an amorphous, nano- or microcrystalline silicon layer and a thin transparent conductive oxide (TCO) layer as passivating and conducting layers. These cells are processed at low temperatures, typically around 200°C, and require accordingly low-temperature metal pastes for screen printing the contacts, which form a contact only on top of the TCO without penetrating into the layers underneath. The second type of cells are cells with high temperature passivating contacts, which can be processed at temperatures above 800°C, so called TOPCon (Tunnel Oxide Passivated Contact) or POLO (Polysilicon on Oxide) cells. CN 113 611 774 A discloses a TOPCON solar cell.

In TOPCon cells, the layer stack comprises a thin silicon oxide interlayer, typically 1.0-1.5 nm thick (a so called "tunnel oxide" layer), and a layer of polycrystalline silicon (poly-Si), possibly containing other elements like carbon, oxygen and hydrogen and doped with elements like boron or phosphorus. Silicon nitride is deposited on top of poly-Si as antireflective coating and optionally as source of hydrogen. Hydrogen is released from the silicon nitride during annealing at high temperatures and diffuses within the layer stack, which provides additional passivation.

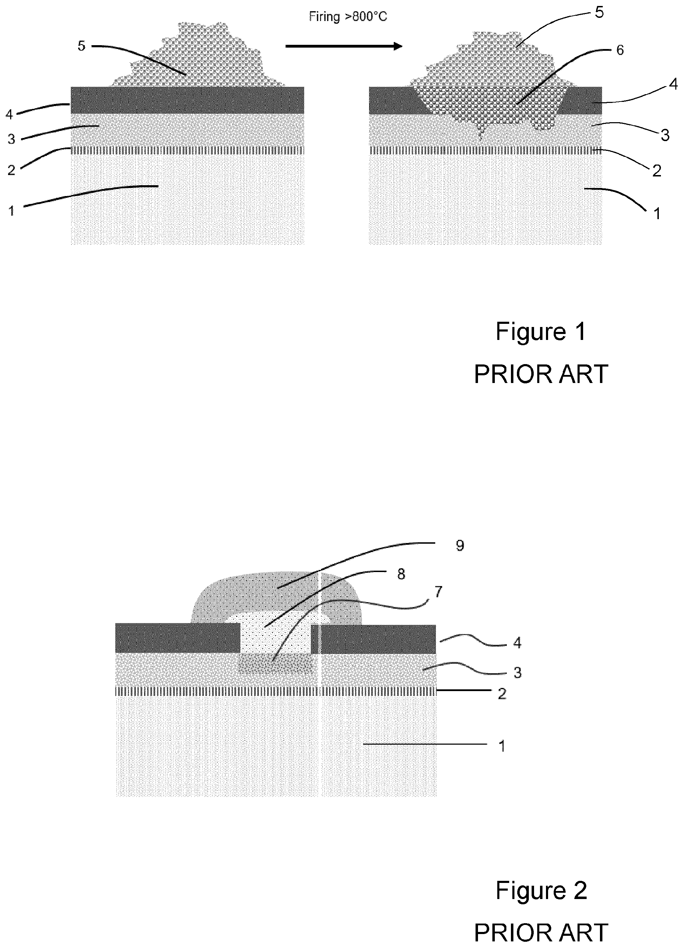

The standard metallization technique for TOPCon cells is screen printing of a line grid using a silver particle paste. The paste is "fired-through" the silicon nitride at about 850°C to form the contact within the poly-Si passivating layer. The paste has to reach deep enough into the poly-Si layer to form a low resistivity contact, preferably below 10 mΩ•cm². However, formation of spikes through the poly-Si to the bulk c-Si substrate must be avoided as it would cause recombination losses. Therefore, relatively thick poly-Si layers are required, typically about 100 nm thick. This type of cell is depicted in Figure 1, the image on the left representing the contact directly after printing of the silver particle paste 5 and the image on the right representing the structure after firing-through of the contact. In this figure, a crystalline silicon (c-Si) substrate 1 is provided, upon which is provided a tunnel oxide layer 2 (typically 1-1.5 nm SiOx), upon which a passivating layer 3 (typically approximately 100 nm thick poly-Si) is provided, upon which a dielectric layer (typically approximately 100 nm thick SiNₓ) is deposited. The contact is formed by screen printed metal particle paste 5 (typically approximately 10 µm thick). This is then fired-through at approximately 850°C, giving the structure on the right, with the zone 6 of fired-through paste penetrating through the dielectric layer 4 and making contact with the underlying passivating layer 3.

An alternative metallization method is illustrated in figure 2, and involves electrodeposition of nickel and copper on the passivating layer 3 of poly-Si layer after patterning the dielectric layer 4 by opening it up with a laser, as described in B. Grübel et al., "Direct Contact Electroplating Sequence Without Initial Seed Layer for Bifacial TOPCon Solar Cell Metallization", DOI: 10.1109/JPHOTOV.2021.3051636. This laser exposure causes laser damage to the passivating layer 3 in zone 7. Upon the exposed portion of the passivating layer 3, nickel 8 is electroplated (typically approximately 1 µm thick), which serves as a barrier layer between the poly-Si and the subsequently electroplated copper 9 (typical thickness approximately 10 µm). Because of laser damage in zone 7, a relatively thick passivating layer 3 is required, at least 70 nm thick.

The disadvantage of poly-Si passivating layers 3 is their parasitic light absorption. Every 10 nm of poly-Si causes a significant loss of photogenerated current in the final device, in the range of 0.5 mA/cm². Because of this parasitic absorption, poly-Si layers are usually applied only on the rear of solar cells, and on the front side a conventional diffused doped layer is formed, e.g. boron emitter on n-type c-Si, coated with aluminum oxide (Al₂O₃) and silicon nitride (SiNₓ).

Research efforts have been focused on reduction of the parasitic absorption, on patterning and localization of the poly-Si layer only underneath the metal grid and on the development of alternative, more transparent passivating layers like transition metal oxides (TMOs), e.g. molybdenum oxide (MOₓ), in order to enable production of high efficiency solar cells with passivating contacts on both sides.

Several approaches for copper plated metallization have been developed to replace silver in solar cell manufacturing, beside the standard process for high temperature cells with laser nitride opening and nickel and copper plating directly on either silicon doped in a diffusion process (e.g. on PERC cells) or on a poly-Si passivating layer.

For heterojunction cells, a process of reinforcement of a screen-printed seed-grid with chemically or electrochemically deposited metals, and with a dielectric layer as plating mask, is described in EP2489076B1 and US9246026B2. The corresponding contact structure is shown in Figure 3. The process comprises the following steps on a heterojunction cell precursor having a passivating layer 3 and a thin transparent conductive oxide (TCO) 10 on a c-Si substrate 1: printing a seed-grid using a metal particle paste 5, deposition of a dielectric layer 4 on the entire wafer and chemical or electrochemical reinforcement of the printed seed-grid with electrodeposited copper 9. Due to the rough surface morphology of the printed paste 5 and its discontinuous nature because it consists of metal particles of different shape and of organic components, resembling a spongy structure , the dielectric layer 4 is discontinuous, i.e. has voids on top of the paste and where it is deposited, its thickness is significantly lower than on the TCO 10 (because of significantly bigger surface per surface area than the surrounding, typically pyramid-textured wafer surface), which enables current flow for electrodeposition and ensures good contact between the cured metal paste 5 and the electrodeposited copper 9. Indeed, this latter even enters within the structure of the paste 5 where the dielectric layer 4 is not present, further insuring excellent contact therebetween. These processes are only applicable on substrates with a TCO 10 on the surface, the metal particle paste 5 is thermally treated at about 200°C, and as a result the contact is formed only on top of the TCO 10 with no firing-through.

Figure 4 illustrates the contact structure resulting from a plating process described in US8236604B2. This contact is formed on a substrate 1, which is a photovoltaic structure with intrinsic and doped passivating layers and optionally also interlayers, with a TCO 10 on its surface and a patterned sputtered metal seed layer 12, upon which nickel 8 (optional) and copper 9 are electroplated after patterning of a dielectric layer 4, which serves as plating mask. The thickness of the dielectric layer 4 is about 100 nm, whereas several microns of metals are electrodeposited. The formed lines have lower aspect ratio than those defined by a conventional thick organic resist.

An object of the present invention is to provide a photovoltaic device with a contact structure which is economic to produce, exhibits low resistivity and well-adhered metal contacts allowing to use thin passivating layers, preferably thinner than 50 nm, in order to minimize the parasitic absorption and to enable higher photogenerated current and thus higher photoconversion efficiency. The possibility to reduce or fully eliminate the use of relatively expensive silver by utilizing copper as the main conducting material for the photogenerated current is also desirable.

### Disclosure of the Invention

More precisely, the invention relates to a photovoltaic device as defined in independent claim 1. This photovoltaic device comprises:
- a silicon-based substrate, typically monocrystalline silicon;
- a tunneling layer, typically of SiOₓ, provided upon said silicon-based substrate, typically directly thereupon;
- a passivating layer, typically of poly-Si, provided upon said tunneling layer, typically directly thereupon but the presence of at least one intermediate layer is not excluded; other possible materials include SiC, poly-Si, poly-SiOₓ, a-Si / nc-Si / µc-Si, MOₓ, WOₓ, TiOₓ, optionally doped with elements like boron or phosphorus;
- an electrical contact structure situated upon said passivating layer;
- a dielectric layer, typically of SiOₓ, SiNₓ, SiOₓN_{y} or Al₂O₃, provided upon said passivating layer, typically directly thereupon but the presence of at least one intermediate layer is not excluded.

According to the invention, said electrical contact structure comprises:
- a patterned metal seed layer, typically applied by sputtering and comprising one or more of Ag, Al, Co, Cr, Mo, Ni, NiV, Ta, Ti, W, WTi, Cu, Ni, and alloys thereof provided upon said passivating layer and defining seeded zones in which said patterned metal seed layer is present, patterned metal seed layer typically being directly upon the passivating layer, but the presence of at least one intermediate layer is not excluded;
- a metal particle paste, typically of silver or silver-containing metal particles and typically defining conducting electrical tracks and/or busbars, provided exclusively upon said patterned metal seed layer in said seeded zones, typically by printing. Said dielectric layer extends over said metal particle paste discontinuously; and
- a metallic plating layer, typically of copper, nickel, tin or alloys thereof, provided upon said dielectric layer in said seeded zones and in electrical connection with said metal particle paste.

This arrangement does not require a TCO layer (although one may alternatively be provided upon the passivating layer) and permits a relatively thin passivating layer, since no firing-through of metal particle paste is required. This reduces parasitic losses in the photovoltaic device. The metal seed layer is in intimate contact with the passivating layer (giving good adhesion and low contact resistivity) and is also in good electrical connection with the metallic particle paste above as well as with the plated / electrodeposited layer, forming overall a low resistivity contact. Furthermore, since the metal particle paste can act as an etching mask for etching the metal seed layer outside of the seeded zones, extra masking steps can be eliminated. Also, since masking and/or selective removal are not required for depositing the dielectric layer, yet further masking steps can be eliminated and the photovoltaic device can be manufactured economically. Finally, the use of silver can be reduced compared to certain prior art contact structures since the bulk of the conductivity is provided by the metallic plating which can be copper, nickel, tin or similar, thereby further reducing costs.

Advantageously, said silicon-based substrate is of monocrystalline silicon.

Advantageously, wherein said patterned metal seed layer comprises a plurality of sub-layers of at least two different metals. This is particularly useful in order to further improve the adhesion of the seed layer, since a first metal such as a contacting and adhesion layer (e.g. of Ag, Al, Co, Cr, Mo, Ni, NiV, Ta, Ti, W, WTi and/or alloys thereof) can be provided in direct contact with the passivation layer, and then capped with a second metal (e.g. Cu, Ni, Sn and/or alloys thereof ) with higher specific conductivity to support uniform distribution of the current for electrodeposition and as the uppermost layer a metal forming a low resistivity contact to the subsequently printed metal particle paste provided thereupon.

Advantageously, said metal particle paste comprises metal particles with a diameter of 1 µm to 10 µm, preferably 2 µm to 5 µm. Smaller metal particles in the nanometer range may also be present. This particle range helps to ensure sufficient openings in the discontinuous dielectric layer over the metal particle paste to ensure good electrical contact between the metal particle paste and the plated metal layer.

Advantageously, said tunneling layer has a thickness between 1 nm and 1.5 nm, and is preferably made of SiOₓ.

Advantageously, said passivating layer comprises (and is indeed majoritarily) one of SiC, a-Si, nc-Si, µc-Si, poly-Si, poly-SiOₓ or a transition metal oxide such as a tungsten oxide, a molybdenum oxide or a titanium oxide, said passivating layer optionally being doped with a dopant such as boron or phosphorus.

Advantageously, said passivating layer has a thickness of less than 50 nm and is preferably of polycrystalline silicon. This relatively low thickness helps to reduce parasitic losses typically incurred by a passivating layer.

Advantageously, said passivating layer is thinner outside of said seeded zones than inside said seeded zones, further reducing parasitic losses typically incurred by a passivation layer.

Advantageously, said dielectric layer has a thickness of 50 nm to 150 nm outside of said seeded zones, and is preferably of one of SiOₓ, SiNₓ, SiOₓN_{y} or Al₂O₃. Al₂O₃ is typically applied in the thickness range 5-20 nm. Further advantageously, the dielectric layer may be a layer stack comprising sub-layers of these materials.

The invention further relates to a method of manufacturing a photovoltaic device as defined above. This method comprises steps of:
- providing a silicon-based substrate, typically of monocrystalline silicon, with a tunneling layer (typically of SiOx) provided thereupon and a passivating layer (typically of poly-Si) provided upon said tunneling layer; subsequently
- depositing a metal seed layer upon said passivating layer, said metal seed layer being deposited on the whole surface and typically comprising one or more of Ag, Al, Co, Cr, Mo, Ni, NiV, Ta, Ti, W, WTi, Cu, Ni or alloys thereof; subsequently
- printing a metal particle paste, typically of silver or silver-containing metal particles and defining conducting electrical tracks and/or busbars, upon said metal seed layer, said metal particle paste being arranged to serve as an etching mask to define seeded zones in which the seed layer will remain in the final device; subsequently
- etching away said metal seed layer outside of said seeded zones so as to expose said passivating layer outside of said seeded zones; subsequently
- depositing a dielectric layer on said exposed passivating layer (i.e. the portion of the passivating layer outside of the seeded zones and which is not covered by the patterned metal seed layer) and said metal particle paste such that said dielectric layer is discontinuous, i.e. has voids on said metal particle paste; subsequently
- forming a metallic plating layer, typically by electroplating or electroless plating of copper, nickel, tin or similar, in superposition of said metal particle paste (i.e. at least in said seeded zones) and in electrical connection therewith.

This method does not require a TCO layer (although one may optionally be deposited upon the passivating layer in a corresponding step) and permits a relatively thin passivation layer, since no firing-through of metal particle paste is required. This reduces parasitic losses in the photovoltaic device. The metal seed layer is in intimate contact with the passivating layer (giving good adhesion and low contact resistivity) and is also in good electrical connection with the metallic particle paste above as well as with the metallic plating layer, reducing resistivity. Furthermore, since the printed metal particle paste acts as an etching mask for etching the metal seed layer outside of the seeded zones, extra masking steps can be eliminated for forming the metal seed layer. Also, since masking and/or selective removal are not required for depositing the dielectric layer, further masking steps can be eliminated and the photovoltaic device can be manufactured economically. Finally, the use of silver can be reduced compared to certain prior art contact structures since the bulk of the conductivity is provided by the metallic plating which can be copper, nickel, tin or similar (or alloys thereof), thereby further reducing costs.

Advantageously, before said step of depositing a dielectric layer, said passivating layer is etched back outside of said seeded zones to reduce its thickness outside of said seeded zones. Parasitic losses due to the passivating layer can hence be further reduced.

Advantageously, an annealing step is carried out after deposition of said dielectric layer, either directly after its deposition or after deposition of the metallic plating, in order to improve passivation by the migration of hydrogen from the dielectric layer into the passivating layer. This step may also be used to cure the metal particle paste at the same time, which is procedurally efficient.

Advantageously, said metallic seed layer is formed by physical vapour deposition, preferably by sputtering.

Advantageously, said metallic seed layer is deposited as at least two sublayers of different metals. This is particularly useful in order to improve the adhesion of the seed layer, since a first metal such as a contacting and adhesion layer (e.g. of Ag, Al, Co, Cr, Mo, Ni, NiV, Ta, Ti, W or WTi and alloys thereof) can be provided in direct contact with the passivation layer, and then capped with a second metal (e.g. Cu, Ni, Sn and/or alloys thereof ) with high lateral conductivity for uniform distribution of the current for electrodeposition and as the uppermost layer a metal forming a low resistivity contact to the subsequently printed metal particle paste layer provided thereupon.

Advantageously, said silicon-based substrate is of monocrystalline silicon.

Advantageously, at least one of the following is true:
said metal particle paste comprises also metal particles with a diameter of 1 µm to 10 µm, preferably 2 µm to 5 µm, however the presence of smaller particles as well is not excluded;
said tunneling layer has a thickness between 1 nm and 1.5 nm, and is preferably made of SiOx;
said passivating layer has a thickness of less than 50 nm and is preferably of polycrystalline silicon, SiC, poly-SiOₓ, a-Si / nc-Si / µc-Si, MOₓ, WOₓ, TiOₓ, optionally doped with elements such as boron or phosphorus;
said dielectric layer has a thickness of 50 nm to 150 nm outside of said seeded zones, and is preferably one or more of SiOₓ, SiNₓ, SiOₓN_{y} or Al₂O₃., this latter having a thickness of 5-20nm. The dielectric layer may be a multilayer comprising a plurality of sub-layers of these substances.

### Brief Description of the Figures

Further details of the invention will become apparent upon reading the detailed description, in reference to the following figures, in which:

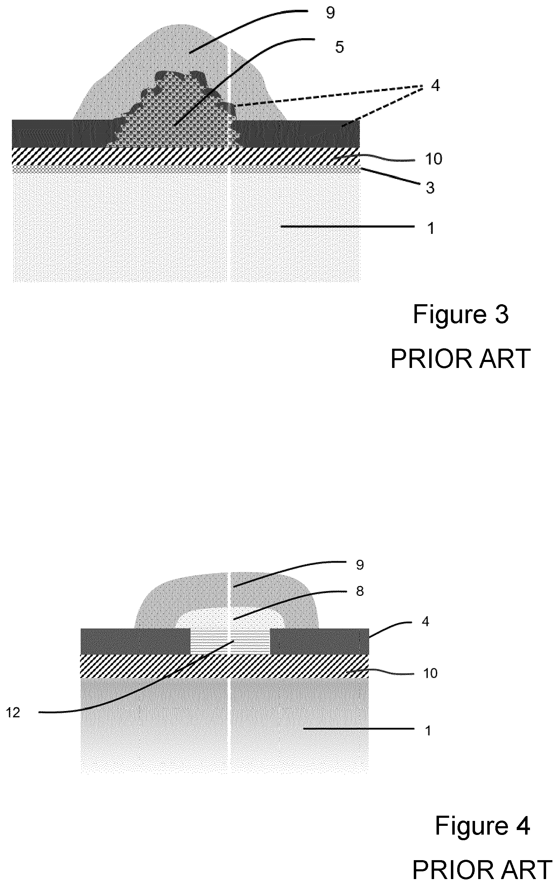

- Figures 1 to 4 illustrate prior art contact structures of photovoltaic devices;
- Figure 5 illustrates an embodiment of a photovoltaic device according to the invention in partial view, focusing on its contact structure;
- Figure 6 illustrates a further embodiment of a photovoltaic device according to the invention in partial view, focusing on its contact structure;
- Figures 7 and 8 illustrate a method of manufacture according to the invention, and
- Figure 9 illustrates a yet further embodiment of a photovoltaic device according to the invention in partial view, focusing on its contact structure.

### Embodiments of the Invention

In the following, unless otherwise specified, further intermediate layers are possible between any two given layers where one is described as being "on" or "upon" the other. Furthermore, in the interests of clarity and following the general practice in the field, the surface texture of the layers has not been represented. This is typically comprised of pyramidal forms, as is generally known.

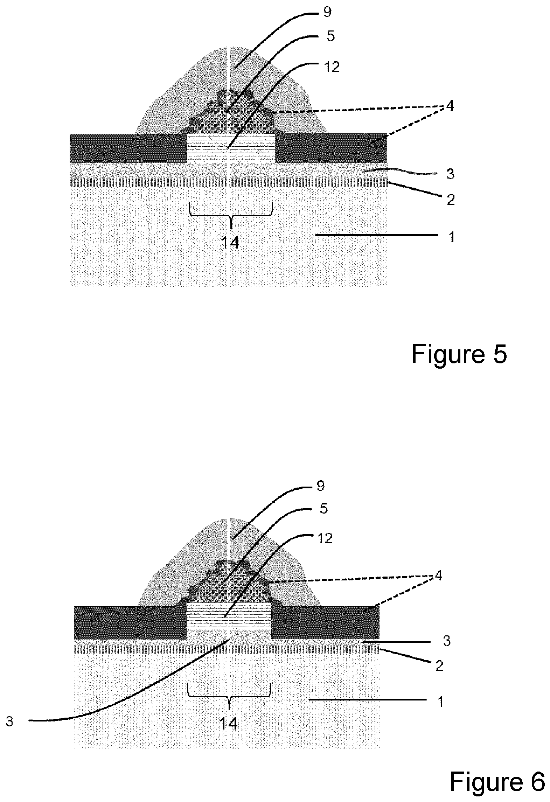

Figure 5 illustrates a first embodiment of a photovoltaic cell according to the invention, illustrating the contact structure which forms the basis of the invention.

The photovoltaic cell comprises a substrate 1, of appropriately-doped (usually n-type, i.e. with phosphorus doping) crystalline silicon (c-Si) upon which is provided a tunneling layer 2 of oxide (typically SiOₓ with a thickness of 1-1.5 nm), covered with a passivating layer 3 less than 50nm thick, typically of polycrystalline silicon (poly-Si). Other materials which can be used for the passivating layer 3 are SiC, poly-SiOₓ, a-Si / nc-Si / µc-Si, MOₓ, WOₓ, TiOₓ, optionally doped with elements such as boron or phosphorus. Optionally, a transparent conductive oxide (TCO) layer (not illustrated) may be provided upon the passivating layer 3, deposited by any suitable known process, however this is not necessary.

A patterned metallic seed layer 12 is provided in locations where it is desired for electrical contacts to be formed, referred to as "seeded zones" 14, since they are zones in which the metallic seed layer 12 will be present in the final device. This patterned metallic seed layer 12 is typically formed by sputtering, more generally by any suitable form of physical vapor deposition (PVD).

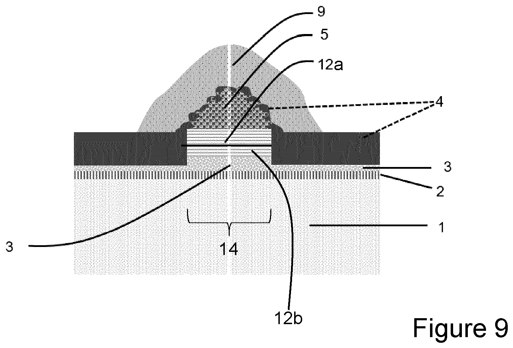

Metallic seed layer 12 may be formed as a single layer of e.g. Cu, Ni, Sn or similar, or as a layer stack of a plurality of sublayers 12a, 12b of different metals as illustrated in figure 9, such as a contacting and adhesion layer (e.g. of Ag, Al, Co, Cr, Mo, Ni, NiV, Ta, Ti, W or WTi or alloys thereof) in direct contact with the passivation layer 3, and a second metal (e.g. Cu, Ni, Sn and/or alloys thereof) with relatively high specific conductivity to support uniform distribution of the current for electrodeposition and as the uppermost layer a metal forming a low resistivity contact to the subsequently printed metal particle paste 5 provided thereupon, typically by printing it in the desired zones so as to define tracks and/or busbars. Typical thickness for the metallic seed layer 12 is approximately 100 nm.

Metal particle paste 5 may be classic silver particle paste, or may be a cheaper type of paste such as silver-coated copper, silver-coated nickel or silver-coated silicon particles. This is applied in wet form, dried and then cured at relatively low temperatures of between 150 °C and 500 °C, which does not substantially change the structure of the contact, other than curing the metal particle paste. Annealing at such moderate temperatures does not cause (detectable) interdiffusion of the passivating layer 3 and the metallic seed layer 12 and there is absolutely no observed in-diffusion of the paste into the passivating layer 3, nevertheless the contact resistivity has been observed to be improved, i.e. lowered, most likely due to changes at the interface between these two layers. Typical width is 10-20 µm for the metal particle paste 5 lines, and typical larger particle diameter is 1 µm to 10 µm, and is typically several microns, i.e. 2 µm to 5 µm, however the presence of smaller particles in the nanometer range is also possible. As will become clear below, metal particle paste serves as an etching mask for defining said seeded zones 14.

A dielectric layer 4, typically of SiOₓ, SiNₓ, SiOₓN_{y} or Al₂O₃, is deposited over the whole surface of the passivation layer 3 and metal particle paste 5, the type of this latter being chosen to support/promote the dielectric layer 4 being discontinuous over the metal particle paste 5, allowing electrical contact therewith, the dielectric layer 4 being deposited to an overall extent (thickness etc.) to ensure this discontinuity. Furthermore, the irregular surface of the metal particle paste 5 causes the dielectric layer 4 to be thinner where it is deposited on the metal particle paste 5 than on the regular, typically pyramid textured surface of the exposed passivating layer 3 outside of the seeded zones 14, where is it continuous and is typically 50 nm to 150 nm thick (aside from in the case of Al₂O₃, when it is typically 5 nm to 20 nm). Due to the discontinuous nature and voids of the dielectric layer 4 on the metal particle paste 5, it does not need to be removed and remains within the electrical contact. PECVD, PVD and ALD are the most commonly-used methods for deposition of the dielectric layer 4, with PECVD being preferred since, in general, directional rather than conformal deposition is helpful in order to assure that the metal particle paste 5 is not completely covered by the dielectric layer 5.

Finally, a metallic plating layer 9 is provided over said metal particle paste 5, encapsulating the part of the dielectric layer 4 which is provided thereupon. Since dielectric layer 4 is discontinuous over the metal particle paste 5, a good electrical contact between this latter and the metal plating layer 9 is assured. It has been observed that metallic plating layer 9 is electrodeposited not only on the surface of the metal particle paste 5 but also within its structure, even down to the metallic seed layer 12. This further improves the electrical contact between the metallic plating layer 9, the metal particle paste 5 and even the metallic seed layer 12. Typical materials for the metal plating layer 9 are nickel and copper. A further, non-illustrated solderable capping layer may also be deposited, such as Ag or Sn, by electrodeposition, chemical reduction or ion exchange (e.g. "immersion tin" or "immersion silver"), with typical thicknesses as follows: electrodeposited Sn 2-4 µm, electrodeposited Ag <0.5 µm, immersion Sn 0.8-1.0 µm, immersion Ag 200-300 nm. This helps prevent oxidation of the metal plating layer 9, particularly in the case in which it is copper. Another example of a capping layer to prevent copper oxidation and thus preserve solderability is a so called organic solderability preservative (OSP) as used e.g. in the manufacturing of printed circuit boards. Such an OSP layer comprises of an ordered network of organic molecules (e.g. benzotriazole) intercalated with copper ions, with a Layer thickness typically < 1 µm, more specifically typically 0.1 µm to 0.6 µm.

Figure 6 illustrates a variant of a photovoltaic device according to the invention, which differs from that of figure 5 in that the passivating layer 3 is etched back in the portions which are not covered by the metallic seed layer 12, i.e. out of the seeded zones 14, in order to reduce its thickness typically to between 5nm and 20 nm, and so to further reduce parasitic absorption.

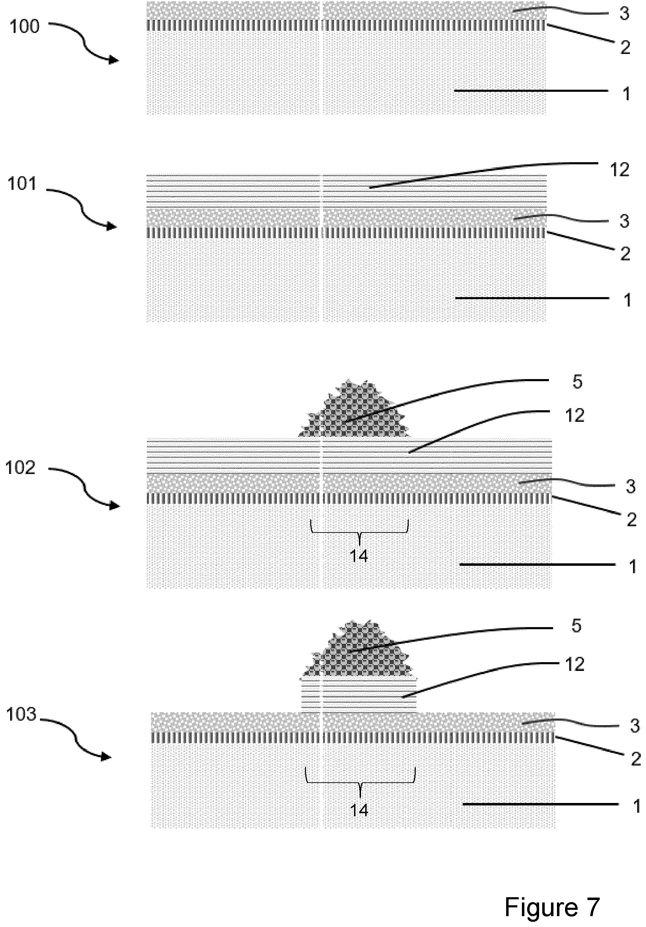

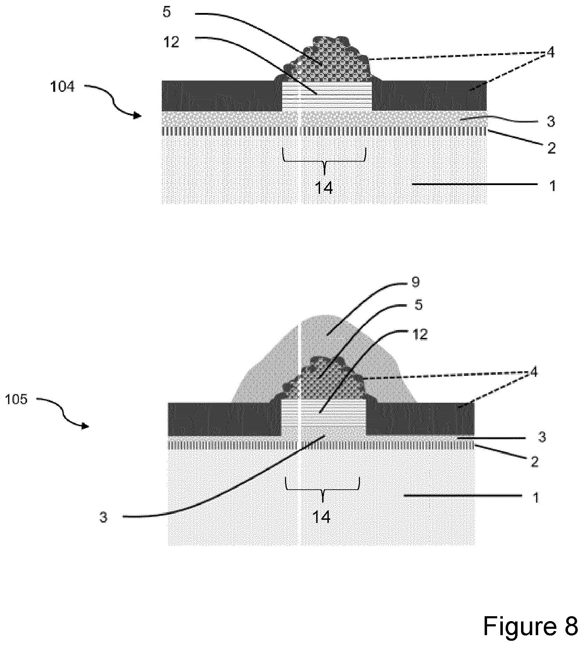

Figures 7 and 8 illustrate a method of manufacturing a photovoltaic device according to the invention. The thicknesses, properties and materials of the various layers are given above in the context of figures 5 and 6.

In step 100, a silicon-based substrate 1 is provided, having previously been etched for saw damage removal, textured (not shown here) and chemically cleaned, as well as having been provided with a tunneling layer 2 and a passivating layer 3 as is generally known to the skilled person. A TCO layer (not illustrated) may be also provided upon the passivating layer 3.

In step 101, metallic seed layer 12 is formed on the entirety of the surface of the passivating layer 3 by physical vapour deposition (PVD), in particular by sputtering. This may be carried out in a single step, or in several steps to obtain a stack of several (typically two) sub-layers 12a, 12b of different metals which constitute the metallic seed layer 12 (as in figure 9).

In step 102, a metal particle paste 5 is printed in a patterned manner, by screen printing, pattern-transfer-printing (PTP) or any other suitable method. Typically, the metal particle paste 5 is printed so as to define grid lines and/or busbars, as is generally known, and serves as an etching mask to define seeded zones 14 in which the metallic seed layer 12 remains after step 103.

The metal particle paste 5 is then dried, e.g. at 100-150°C, and is subsequently cured typically at between 150°C and 500°C. Since the metal seed layer 12 is interposed between the metal particle paste 5 and the passivating layer 3 such that there is no contact between these two latter, the passivating layer 3 can be relatively thin, typically below 50nm thickness, preferably approximately 20 nm thickness since no firing-through or other migration of metal particle paste 5 into the passivating layer 3 can occur, as discussed above.

In step 103, the metal seed layer 12 is etched away in the areas which are not covered by metal particle paste 5, i.e. which are outside of the seeded zones 14.

Optionally, in a non-illustrated step, the passivating layer 3 can be etched back to a reduced thickness in the areas which are not covered by the patterned metal seed layer 12 if the device of figure 6 is to be produced.

In step 104, an insulating, transparent dielectric layer 4 is deposited over the whole of the surface (i.e. over the exposed passivating layer 3 and the metal particle paste 5, that is to say in both the seeded zones 14 and outside of the seeded zones 14). As mentioned above, the size of the metal paste particles / type of paste is chosen so that the surface roughness of the metal particle paste 5 is such that the dielectric layer 4 is thinner over the metal particle paste 5 than over the passivating layer 3, and is furthermore discontinuous (i.e. has voids) over the metal particle paste 5.

In a non-illustrated variant, the step of curing the metal particle paste 5 can be left until after deposition of the dielectric layer 4 in step 104. In this case, annealing occurs and hydrogen is released from the dielectric layer 4 into the passivation layer 3, which further improves the passivation.

Dielectric layer 4 acts as an antireflective coating and as a plating mask in the next step.

In step 105, metallic plating layer 9 is formed, e.g. by electroplating or electroless plating. This does not require further masking: because of the rough surface of the metal particle paste 5, the dielectric layer 4 on top of the metal particle paste 5 is not continuous. These voids expose parts of the metal particle paste 5 which allow current for electroplating (applied to the metal particle paste 5 tracks) to pass through and copper and/or other metals can be deposited, whereas the surface in between the metal particle paste 5 lines is tightly covered by the dielectric and fully protected against electrolytes. As a result, metallic plating layer 9 is formed according to the pattern defined by the metal particle paste 5. In the case of electroless plating (such as autocatalytic plating), the exposed metal particle paste 5 portions are exposed to the plating solution and seed the formation of the metallic plating layer 9.

This eliminates further steps of masking and mask removal, which makes the method of the invention particularly economic to carry out.

The current imposed on the cell for electrodeposition is usually significantly lower than the photogenerated current in the final device, usually below 10% of the photogenerated current. Hence, a metal particle paste 5 with lower conductivity than a standard silver paste can be used for grid formation, for instance a paste with silver-coated copper particles, silver-coated-nickel or silver-coated-silicon particles. It is also conceivable that a silver-free paste could be used.

Depending on whether an etch-back of the dielectric layer 3 was carried out or not, a device according to figure 5 or 6 is hence obtained.

Finally, an annealing step can also be carried out after step 105, in order to release hydrogen from the dielectric layer 4 into the passivation layer 3 to further improve passivation.

Although the invention has been described in connection with particular embodiments, variations thereto are possible without departing from the scope of protection as defined in the appended claims.

## Claims

1. Photovoltaic device comprising:
- a silicon-based substrate (1);
- a tunneling layer (2) provided upon said silicon-based substrate (1);
- a passivating layer (3) provided upon said tunneling layer (2);
- an electrical contact structure (12, 5, 9) situated upon said passivating layer (3);
- a dielectric layer (4) provided upon said passivating layer (3); wherein said electrical contact structure (12, 5, 9) comprises:
- a patterned metal seed layer (12) provided upon said passivating layer (3) and defining seeded zones (14); **characterised in that** said electrical contact structure (12, 5, 9) further comprises:
- a metal particle paste (5) provided exclusively upon said patterned metal seed layer (12) in said seeded zones (14), said dielectric layer (4) extending over said metal particle paste (5) discontinuously; and
- a metallic plating layer (9) provided upon said dielectric layer (4) in said seeded zones (14) and in electrical connection with said metal particle paste (5).

2. Photovoltaic device according to claim 1, further comprising a layer of transparent conductive oxide situated upon said passivation layer (3).

3. Photovoltaic device according to any preceding claim, wherein said patterned metal seed layer (12) comprises a plurality of sub-layers (12a, 12b) of at least two different metals.

4. Photovoltaic device according to any preceding claim, wherein said metal particle paste (5) comprises metal particles with a diameter of 1 µm to 10 µm, preferably 2 µm to 5 µm.

5. Photovoltaic device according to any preceding claim, wherein passivating layer (3) comprises one of SiC, a-Si, nc-Si, µc-Si, poly-Si, poly-SiOx or a metal oxide such as a tungsten oxide, a molybdenum oxide or a titanium oxide, said passivating layer optionally being doped with a dopant such as boron or phosphorus

6. Photovoltaic device according to any preceding claim, wherein said passivating layer (3) has a thickness of less than 50 nm.

7. Photovoltaic device according to the preceding claim, wherein said passivating layer (3) is thinner outside of said seeded zones (14) than inside said seeded zones (14).

8. Photovoltaic device according to any preceding claim, wherein said dielectric layer (3) has a thickness of 50 nm to 150 nm outside of said seeded zones (14), and is preferably of one of SiOₓ, SiNₓ, SiOₓN_{y}. or Al₂O₃, this latter having a thickness of 5-20 nm.

9. Method of manufacturing a photovoltaic device according to any preceding claim, comprising steps of:
- providing a silicon-based substrate (1) with a tunneling layer (2) provided thereupon and a passivating layer (3) provided upon said tunneling layer (2);
- depositing a metal seed layer (12) upon said passivating layer;
- printing a metal particle paste (5) upon said metal seed layer (12), said metal particle paste (5) being arranged to serve as an etching mask to define seeded zones (14);
- etching away said metal seed layer (12) outside of said seeded zones (14) so as to expose said passivating layer (3) outside of said seeded zones (14);
- depositing a dielectric layer (4) on said exposed passivating layer (3) and said metal particle paste (5) such that said passivating layer (4) is discontinuous on said metal particle paste (5);
- forming a metallic plating layer (9) in superposition of said metal particle paste (5) and in electrical connection therewith.

10. Method according to the preceding claim, wherein, before said step of depositing said dielectric layer (5), said passivating layer (3) is etched back outside of said seeded zones (14) to reduce its thickness outside of said seeded zones (14).

11. Method according to one of claims 9 or 10, wherein an annealing step is carried out after deposition of said dielectric layer (4).

12. Method according to one of claims 9-11, wherein said metallic seed layer (12) is formed by physical vapour deposition, preferably by sputtering.

13. Method according to one of claims 9-12, wherein said metallic seed layer (12) is deposited as at least two sublayers (12a, 12b) of different metals.

14. Method according to one of claims 9-13, further comprising a step of depositing layer of transparent conductive oxide upon said passivation layer (3).

15. Method according to one of claims 9-14, wherein at least one of the following is true:
- said metal particle paste (5) comprises metal paste particles with a diameter of 1 µm to 10 µm, preferably 2 µm to 5 µm;
- said tunneling layer (2) has a thickness between 1 nm and 1.5 nm, and is preferably made of SiOₓ;
- said passivating layer (3) has a thickness of less than 50 nm and is preferably of polycrystalline silicon, SiC, poly-SiOₓ, a-Si / nc-Si / µc-Si, metal oxides such as MOₓ, WOₓ, TiOₓ, optionally doped with elements such as boron or phosphorus;
- said dielectric layer (4) has a thickness of 50 nm to 150nm outside of said seeded zones, and preferably comprises of one or more of SiOₓ, SiNₓ, SiOₓN_{y}, or Al₂O₃, this latter having a thickness of 5-20 nm.

## Patentansprüche

1. Photovoltaikvorrichtung, umfassend:
- ein Substrat auf Siliziumbasis (1);
- eine auf dem Substrat auf Siliziumbasis (1) angeordnete Tunnelschicht (2);
- eine auf der Tunnelschicht (2) angeordnete Passivierungsschicht (3);
- eine auf der Passivierungsschicht (3) angeordnete elektrische Kontaktstruktur (12, 5, 9);
- einer dielektrischen Schicht (4), die auf der Passivierungsschicht (3) vorgesehen ist;
wobei die elektrische Kontaktstruktur (12, 5, 9) umfasst:
- eine strukturierte Metallkeimschicht (12), die auf der Passivierungsschicht (3) vorgesehen ist und Keimzonen (14) definiert; **dadurch gekennzeichnet, dass** die elektrische Kontaktstruktur (12, 5, 9) ferner umfasst:
- eine Metallpartikelpaste (5), die ausschließlich auf der strukturierten Metallkeimschicht (12) in den Keimzonen (14) vorgesehen ist, wobei sich die dielektrische Schicht (4) diskontinuierlich über die Metallpartikelpaste (5) erstreckt; und
- eine Metallbeschichtungsschicht (9), die auf der dielektrischen Schicht (4) in den Keimzonen (14) vorgesehen ist und in elektrischer Verbindung mit der Metallpartikelpaste (5) steht.

2. Photovoltaikvorrichtung nach Anspruch 1, die ferner eine Schicht aus transparentem leitfähigem Oxid umfasst, die auf der Passivierungsschicht (3) angeordnet ist.

3. Photovoltaikvorrichtung nach einem der vorstehenden Ansprüche, wobei die strukturierte Metallkeimschicht (12) eine Vielzahl von Unterschichten (12a, 12b) aus mindestens zwei verschiedenen Metallen umfasst.

4. Photovoltaikvorrichtung nach einem der vorstehenden Ansprüche, wobei die Metallpartikelpaste (5) Metallpartikel mit einem Durchmesser von 1 µm bis 10 µm, vorzugsweise 2 µm bis 5 µm, umfasst.

5. Photovoltaikvorrichtung nach einem der vorstehenden Ansprüche, wobei die Passivierungsschicht (3) eines der folgenden Materialien umfasst: SiC, a-Si, nc-Si, µc-Si, poly-Si, poly-SiOx oder ein Metalloxid wie Wolframoxid, Molybdänoxid oder Titanoxid, wobei die Passivierungsschicht optional mit einem Dotierstoff wie Bor oder Phosphor dotiert ist

6. Photovoltaikvorrichtung nach einem der vorstehenden Ansprüche, wobei die Passivierungsschicht (3) eine Dicke von weniger als 50 nm aufweist.

7. Photovoltaikvorrichtung nach dem vorstehenden Anspruch, wobei die Passivierungsschicht (3) außerhalb der Keimzonen (14) dünner ist als innerhalb der Keimzonen (14).

8. Photovoltaikvorrichtung nach einem der vorstehenden Ansprüche, wobei die dielektrische Schicht (3) außerhalb der Keimzonen (14) eine Dicke von 50 nm bis 150 nm aufweist und vorzugsweise aus einem der Materialien SiOₓ, SiNₓ, SiOₓN_{y} oder Al₂O₃ besteht, wobei letzteres eine Dicke von 5-20 nm aufweist.

9. Verfahren zur Herstellung einer photovoltaischen Vorrichtung nach einem der vorstehenden Ansprüche, umfassend die folgenden Schritte:
- Bereitstellen eines Substrats (1) auf Siliziumbasis mit einer darauf aufgebrachten Tunnelschicht (2) und einer auf der Tunnelschicht (2) aufgebrachten Passivierungsschicht (3);
- Aufbringen einer Metallkeimschicht (12) auf die Passivierungsschicht;
- Aufdrucken einer Metallpartikelpaste (5) auf die Metallkeimschicht (12), wobei die Metallpartikelpaste (5) so angeordnet ist, dass sie als Ätzmaske dient, um Keimzonen (14) zu definieren;
- Wegätzen der Metallkeimschicht (12) außerhalb der Keimzonen (14), um die Passivierungsschicht (3) außerhalb der Keimzonen (14) freizulegen;
- Aufbringen einer dielektrischen Schicht (4) auf die freigelegte Passivierungsschicht (3) und die Metallpartikelpaste (5), derart, dass die Passivierungsschicht (4) auf der Metallpartikelpaste (5) unterbrochen ist;
- Bilden einer metallischen Plattierungsschicht (9) in Überlagerung mit der Metallpartikelpaste (5) und in elektrischer Verbindung damit.

10. Verfahren nach dem vorstehenden Anspruch, wobei vor dem Schritt des Aufbringens der dielektrischen Schicht (5) die Passivierungsschicht (3) außerhalb der Keimzonen (14) zurückgeätzt wird, um ihre Dicke außerhalb der Keimzonen (14) zu verringern.

11. Verfahren nach einem der Ansprüche 9 oder 10, wobei nach dem Aufbringen der dielektrischen Schicht (4) ein Temperungsschritt durchgeführt wird.

12. Verfahren nach einem der Ansprüche 9-11, wobei die metallische Keimschicht (12) durch physikalische Gasphasenabscheidung, vorzugsweise durch Sputtern, gebildet wird.

13. Verfahren nach einem der Ansprüche 9-12, wobei die metallische Keimschicht (12) als mindestens zwei Unterschichten (12a, 12b) aus unterschiedlichen Metallen abgeschieden wird.

14. Verfahren nach einem der Ansprüche 9-13, das ferner einen Schritt zum Abscheiden einer Schicht aus transparentem leitfähigem Oxid auf der Passivierungsschicht (3) umfasst.

15. Verfahren nach einem der Ansprüche 9 bis 14, wobei mindestens eine der folgenden Aussagen zutrifft:
- die Metallpartikelpaste (5) umfasst Metallpastenpartikel mit einem Durchmesser von 1 µm bis 10 µm, vorzugsweise 2 µm bis 5 µm;
- die Tunnelschicht (2) hat eine Dicke zwischen 1 nm und 1,5 nm und besteht vorzugsweise aus SiOₓ;
- die Passivierungsschicht (3) eine Dicke von weniger als 50 nm aufweist und vorzugsweise aus polykristallinem Silizium, SiC, Poly-SiOₓ, a-Si / nc-Si / µc-Si, Metalloxiden wie MOₓ, WOₓ, TiOₓ besteht, die gegebenenfalls mit Elementen wie Bor oder Phosphor dotiert sind;
- die dielektrische Schicht (4) außerhalb der Keimzonen eine Dicke von 50 nm bis 150 nm aufweist und vorzugsweise aus einem oder mehreren der folgenden Materialien besteht: SiOₓ, SiNₓ, SiOₓN_{y} oder Al₂O₃, wobei letzteres eine Dicke von 5-20 nm aufweist.

## Revendications

1. Dispositif photovoltaïque comprenant :
- un substrat à base de silicium (1) ;
- une couche à effet tunnel (2) disposée sur ledit substrat à base de silicium (1) ;
- une couche de passivation (3) disposée sur ladite couche à effet tunnel (2) ;
- une structure de contact électrique (12, 5, 9) située sur ladite couche de passivation (3) ;
- une couche diélectrique (4) disposée sur ladite couche de passivation (3) ;
dans lequel ladite structure de contact électrique (12, 5, 9) comprend :
- une couche germinale métallique structurée (12) disposée sur ladite couche de passivation (3) et définissant des zones de germe (14) ; **caractérisé en ce que** ladite structure de contact électrique (12, 5, 9) comprend en outre :
- une pâte de particules métalliques (5) disposée exclusivement sur ladite couche germinale métallique structurée (12) dans lesdites zones de germe (14), ladite couche diélectrique (4) s'étendant de manière discontinue sur ladite pâte de particules métalliques (5) ; et
- une couche de placage métallique (9) disposée sur ladite couche diélectrique (4) dans lesdites zones de germe (14) et en connexion électrique avec ladite pâte de particules métalliques (5).

2. Dispositif photovoltaïque selon la revendication 1, comprenant en outre une couche d'oxyde transparent conducteur située sur ladite couche de passivation (3).

3. Dispositif photovoltaïque selon l'une quelconque des revendications précédentes, dans lequel ladite couche germinale métallique structurée (12) comporte une pluralité de sous-couches (12a, 12b) d'au moins deux métaux différents.

4. Dispositif photovoltaïque selon l'une quelconque des revendications précédentes, dans lequel ladite pâte de particules métalliques (5) comprend des particules métalliques d'un diamètre compris entre 1 µm et 10 µm, de préférence entre 2 µm et 5 µm.

5. Dispositif photovoltaïque selon l'une quelconque des revendications précédentes, dans lequel la couche de passivation (3) comprend l'un parmi SiC, a-Si, nc-Si, µc-Si, poly-Si, poly-SiOx ou un oxyde métallique tel qu'un oxyde de tungstène, un oxyde de molybdène ou un oxyde de titane, ladite couche de passivation étant facultativement dopée avec un dopant tel que le bore ou le phosphore

6. Dispositif photovoltaïque selon l'une quelconque des revendications précédentes, dans lequel ladite couche de passivation (3) a une épaisseur inférieure à 50 nm.

7. Dispositif photovoltaïque selon la revendication précédente, dans lequel ladite couche de passivation (3) est plus mince à l'extérieur desdites zones de germe (14) qu'à l'intérieur desdites zones de germe (14).

8. Dispositif photovoltaïque selon l'une quelconque des revendications précédentes, dans lequel ladite couche diélectrique (3) a une épaisseur comprise entre 50 nm et 150 nm à l'extérieur desdites zones de germe (14), et est de préférence de l'un des composés SiOₓ, SiNₓ, SiOₓN_{y} ou Al₂O₃, ce dernier ayant une épaisseur de 5 à 20 nm.

9. Procédé de fabrication d'un dispositif photovoltaïque selon l'une quelconque des revendications précédentes, comprenant les étapes de :
- fournir un substrat à base de silicium (1) sur lequel est disposée une couche à effet tunnel (2) et une couche de passivation (3) disposée sur ladite couche à effet tunnel (2) ;
- déposer une couche germinale métallique (12) sur ladite couche de passivation ;
- imprimer une pâte de particules métalliques (5) sur ladite couche germinale métallique (12), ladite pâte de particules métalliques (5) étant agencée pour servir de masque de gravure afin de définir des zones de germe (14) ;
- graver ladite couche germinale métallique (12) à l'extérieur desdites zones de germe (14) de manière à exposer ladite couche de passivation (3) à l'extérieur desdites zones de germe (14) ;
- déposer une couche diélectrique (4) sur ladite couche de passivation exposée (3) et ladite pâte de particules métalliques (5) de telle sorte que ladite couche de passivation (4) soit discontinue sur ladite pâte de particules métalliques (5) ;
- former une couche de placage métallique (9) en superposition de ladite pâte de particules métalliques (5) et en connexion électrique avec celle-ci.

10. Procédé selon la revendication précédente, dans lequel, avant ladite étape de dépôt de ladite couche diélectrique (5), ladite couche de passivation (3) est gravée en retrait à l'extérieur desdites zones de germe (14) afin de réduire son épaisseur à l'extérieur desdites zones de germe (14).

11. Procédé selon l'une des revendications 9 ou 10, dans lequel une étape de recuit est effectuée après le dépôt de ladite couche diélectrique (4).

12. Procédé selon l'une des revendications 9 à 11, dans lequel ladite couche germinale métallique (12) est formée par dépôt physique en phase vapeur, de préférence par pulvérisation cathodique.

13. Procédé selon l'une des revendications 9 à 12, dans lequel ladite couche germinale métallique (12) est déposée sous la forme d'au moins deux sous-couches (12a, 12b) de métaux différents.

14. Procédé selon l'une des revendications 9 à 13, comprenant en outre une étape de déposition d'une couche d'oxyde transparent conducteur sur ladite couche de passivation (3).

15. Procédé selon l'une des revendications 9 à 14, dans lequel au moins l'une des conditions suivantes est remplie :
- ladite pâte de particules métalliques (5) comprend des particules de pâte métallique d'un diamètre compris entre 1 µm et 10 µm, de préférence entre 2 µm et 5 µm ;
- ladite couche à effet tunnel (2) présente une épaisseur comprise entre 1 nm et 1,5 nm, et est de préférence constituée de SiOₓ ;
- ladite couche de passivation (3) présente une épaisseur inférieure à 50 nm et est de préférence de silicium polycristallin, de SiC, de poly-SiOₓ, d'a-Si / nc-Si / µc-Si, d'oxydes métalliques tels que MOₓ, WOₓ, TiOₓ, facultativement dopés avec des éléments tels que le bore ou le phosphore ;
- ladite couche diélectrique (4) présente une épaisseur comprise entre 50 nm et 150 nm en dehors desdites zones de germe, et comprend de préférence un ou plusieurs parmi SiOₓ, SiNₓ, SiOₓN_{y}, ou Al₂O₃, ce dernier ayant une épaisseur de 5 à 20 nm.
